# EUROPEAN PATENT APPLICATION

(11) **EP 4 550 333 A1**
(43) Date of publication of application: **07.05.2025**
(21) Application number: 24206910.2
(22) Date of filing: 16.10.2024
(51) Int. Cl.: G11C 11/56, G11C 13/00

(54) **MEMORY DEVICE FOR IMPLEMENTING MULTI-LEVEL MEMORY AND METHOD OF IMPLEMENTING MULTI-LEVEL MEMORY BY USING THE MEMORY DEVICE**

(30) Priority: 02.11.2023 KR 20230150293; 27.03.2024 KR 20240042003
(71) Applicant: Samsung Electronics Co., Ltd, Suwon-si, Gyeonggi-do 16677 (KR)
(72) Inventor: LEE, Changseung, 16678 Suwon-si (KR); CHOI, Minwoo, 16678 Suwon-si (KR); KOO, Bonwon, 16678 Suwon-si (KR); SUNG, Hajun, 16678 Suwon-si (KR); YANG, Kiyeon, 16678 Suwon-si (KR)
(74) Representative: Elkington and Fife LLP

(57) **Abstract**

Provided are a memory device for implementing a multi-level memory and a method of implementing a multi-level memory by using the memory device. The memory device includes first and second electrodes apart from each other, a self-selecting memory layer between the first and second electrodes having an ovonic threshold switching characteristic,, including a chalcogenide-based material, and configured to have a threshold voltage varying depending on a polarity of and strength of a voltage applied thereto, and a resistive memory layer between the second electrode and the self-selecting memory layer and having a resistance characteristic varying depending on a voltage applied thereto. The memory device is configured to implement multi-level resistance states by changing at least one of a pulse polarity, a number of pulses, pulse height, and a pulse width of a voltage applied between the first and second electrodes.

## Description

### FIELD OF THE INVENTION

Various example embodiments relate, in general, to a memory device for implementing a multi-level memory and/or a method of implementing a multi-level memory by using the memory device.

### BACKGROUND OF THE INVENTION

As electronic products have become more lightweight and compact, the demand or expectation for high integration of memory devices has increased. A cross-point memory device has a structure in which a word line and a bit line vertically intersect each other and a memory cell is arranged at an intersection area. This structure has the advantage of having a small memory cell in a plan view. In general, a memory cell of a cross-point memory device includes a 2-terminal selector and a memory device connected in series to each other in order to prevent a sneak current between adjacent memory cells. Recently, a self-selecting memory device (SSM) simultaneously functioning as a selector and a memory device has been developed.

### SUMMARY OF THE INVENTION

Provided are a memory device for implementing a multi-level memory and/or a method of implementing a multi-level memory by using the memory device.

Additional aspects will be set forth in part in the description which follows and, in part, will be apparent from the description, or may be learned by practice of various example embodiments.

According to some example embodiments, a memory device includes first and second electrodes apart from each other, a self-selecting memory layer between the first and second electrodes, and including a chalcogenide-based material, having an ovonic threshold switching characteristic, and configured to have a threshold voltage varying depending on a polarity of and strength of a voltage applied thereto, and a resistive memory layer between the second electrode and the self-selecting memory layer and having a resistance characteristic varying depending on a voltage applied thereto. The memory device is configured to implement multi-level resistance states by changing at least one of a pulse polarity, a number of pulses, pulse height, and pulse width of a voltage applied between the first and second electrodes.

Alternatively or additionally according to various example embodiments, provided is a method of implementing a multi-level memory by using a memory device including first and second electrodes apart from each other, a self-selecting memory layer between the first and second electrodes, including a chalcogenide-based material, having an ovonic threshold switching characteristic, and configured to have a threshold voltage varying depending on a polarity of and strength of a voltage applied thereto, and a resistive memory layer between the second electrode and the self-selecting memory layer and having a resistance characteristic varying depending on a voltage applied thereto,. The method includes implementing multi-level resistance states by changing at least one of a pulse polarity, a number of pulses, a pulse height, and a pulse width of a voltage applied between the first and second electrodes.

Alternatively or additionally according to various example embodiments, a memory device includes a plurality of bit lines, a plurality of word lines intersecting the plurality of bit lines, and a plurality of memory cells at positions where the plurality of bit lines and the plurality of word lines intersect each other. Each of the plurality of memory cells includes first and second electrodes apart from each other, a self-selecting memory layer between the first and second electrodes, including a chalcogenide-based material, having an ovonic threshold switching characteristic, and configured to have a threshold voltage varying depending on a polarity of and strength of a voltage applied thereto, and a resistive memory layer between the second electrode and the self-selecting memory layer and having a resistance characteristic varying depending on a voltage applied thereto, The memory device is configured to implement multi-level resistance states by changing at least one of a pulse polarity, a number of pulses, a pulse height, and a pulse width of a voltage applied between the first and second electrodes.

Alternatively or additionally, a multi-level memory device includes a self-selecting memory device having an ovonic threshold switching characteristic and having a threshold voltage varying depending on a polarity of and strength of a voltage applied thereto, a resistive memory device connected in series to the self-selecting memory device and having a resistance characteristic varying depending on a voltage applied thereto, and a memory controller configured to change a height of a pulse voltage of negative (-) polarity applied to the self-selecting memory device.

### BRIEF DESCRIPTION OF THE DRAWINGS

The above and other aspects, features, and advantages of certain example embodiments will be more apparent from the following description taken in conjunction with the accompanying drawings, in which:
FIG. 1 schematically illustrates a cross-section of a memory device according to some example embodiments;
FIG. 2 is a graph illustrating a voltage-current characteristic of a self-selecting memory layer illustrated in FIG. 1;
FIG. 3A is a graph illustrating bias voltages for a SET operation and a read operation applied to the self-selecting memory layer illustrated in FIG. 1;
FIG. 3B is a graph illustrating bias voltages for a RESET operation and a read operation applied to the self-selecting memory layer illustrated in FIG. 1;
FIG. 4 is a graph illustrating a voltage-current characteristic depending on the magnitude (strength) of a write voltage applied to the self-selecting memory layer illustrated in FIG. 1;
FIG. 5 illustrates a change in threshold voltage depending on the number of pulses of a write voltage applied to the self-selecting memory layer illustrated in FIG. 1;
FIG. 6 illustrates a change in threshold voltage depending on the pulse width of a write voltage in a RESET operation of the self-selecting memory layer illustrated in FIG. 1;
FIG. 7 illustrates a change in threshold voltage depending on the pulse width of a write voltage in a SET operation of the self-selecting memory layer illustrated in FIG. 1;
FIGS. 8A and 8B are graphs illustrating a current characteristic depending on the number of pulses of a write voltage applied to a resistive memory layer illustrated in FIG. 1;
FIGS. 9A and 9B are graphs illustrating a current characteristic depending on the pulse height of a write voltage applied to the resistive memory layer illustrated in FIG. 1;
FIGS. 10A and 10B are graphs illustrating a current characteristic depending on the pulse width of a write voltage applied to the resistive memory layer illustrated in FIG. 1;
FIG. 11 schematically illustrates a change in resistance depending on the pulse height and number of pulses of a write voltage applied to the memory device illustrated in FIG. 1;
FIG. 12 schematically illustrates a change in resistance depending on the pulse height and pulse width of a write voltage applied to the memory device illustrated in FIG. 1;
FIG. 13 schematically illustrates a change in resistance depending on the pulse height, number of pulses, and pulse width of a write voltage applied to the memory device illustrated in FIG. 1;
FIG. 14 is a block diagram illustrating a schematic configuration of a memory device according to some example embodiments;
FIG. 15 schematically illustrates a cross-section of a memory device according to some example embodiments;
FIG. 16 is a perspective view schematically illustrating a memory device according to some example embodiments;
FIG. 17 is an enlarged view of one memory cell in the memory device illustrated in FIG. 16;
FIG. 18 is a plan view illustrating an operation of selecting a particular memory cell in the memory device illustrated in FIG. 16;
FIG. 19 is a cross-sectional view schematically illustrating a multi-layer memory device according to some example embodiments;
FIG. 20 is a conceptual diagram schematically illustrating a device architecture applicable to an electronic apparatus according to some example embodiments;
FIG. 21 is a block diagram of a memory system according to some example embodiments; and
FIG. 22 is a block diagram illustrating a neuromorphic apparatus according to some example embodiments, and an external device connected thereto.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the accompanying drawings. Like reference numerals in the drawings will denote like elements, and sizes of elements in the drawings may be exaggerated for clarity and convenience of description. The embodiments described below are merely examples, and various modifications may be made therein.

As used herein, the terms "over" or "on" may include not only "directly over" or "directly on" but also "indirectly over" or "indirectly on". As used herein, the singular forms "a", "an", and "the" are intended to include the plural forms as well, unless the context clearly indicates otherwise. Also, when something is referred to as "including" a component, another component may be further included unless specified otherwise.

The use of the terms "a", "an", and "the" and other similar indicative terms may be construed to cover both the singular and the plural. Unless there is an explicit order or a contrary description, operations constituting a method may be performed in a suitable order and are not necessarily limited to the described order.

Also, as used herein, the terms "units" and "modules" may refer to units that perform at least one function or operation, and the units may be implemented as hardware or software or a combination of hardware and software.

Connections or connection members of lines between the elements illustrated in the drawings may illustratively represent functional connections and/or physical or logical connections and may be represented as various replaceable or additional functional connections, physical connections, or logical connections in an actual apparatus.

All examples or illustrative terms used herein are merely intended to describe the technical concept of the disclosure in detail, and the scope of the disclosure is not limited by these examples or illustrative terms unless otherwise defined in the appended claims.

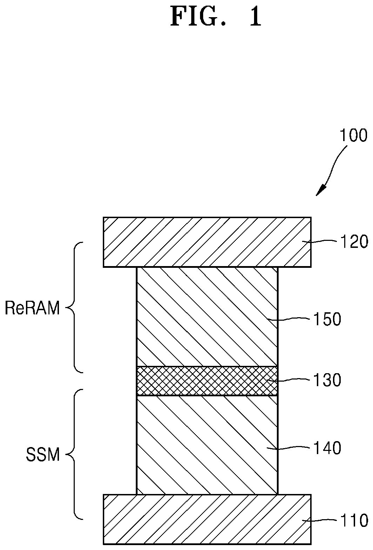

FIG. 1 schematically illustrates a cross-section of a memory device 100 according to some example embodiments.

Referring to FIG. 1, the memory device 100 may include first and second electrodes 110 and 120 arranged apart from each other, a self-selecting memory layer 140 arranged between the first and second electrodes 110 and 120, and a resistive memory layer 150 arranged between the second electrode 120 and the self-selecting memory layer 140.

The first and second electrodes 110 and 120 may function to apply a voltage to the self-selecting memory layer 140 and the resistive memory layer 150. For this purpose, each of the first and second electrodes 110 and 120 may include a metal, a conductive metal nitride, a conductive metal oxide, or any combination thereof. For example, each of the first and second electrodes 110 and 120 may include at least one or any combination of titanium nitride (TiN), titanium silicon nitride (TiSiN), titanium carbon nitride (TiCN), titanium carbon silicon nitride (TiCSiN), titanium aluminum nitride (TiAlN), tantalum (Ta), tantalum nitride (TaN), tantalum silicon nitride (TaSiN), tantalum aluminum nitride (TaAIN), tungsten silicide (WSi), titanium tungsten (TiW), molybdenum nitride (MoN), niobium nitride (NbN), titanium boron nitride (TiBN), zirconium silicon nitride (ZrSiN), tungsten silicon nitride (WSiN), tungsten boron nitride (WBN), zirconium aluminum nitride (ZrAIN), molybdenum aluminum nitride (MoAlN), titanium aluminum (TiAl), titanium oxynitride (TiON), titanium aluminum oxynitride (TiAlON), tungsten oxynitride (WON), tantalum oxynitride (TaON), silicon carbon (SiC), silicon carbon nitride (SiCN), carbon nitride (CN), tantalum carbon nitride (TaCN), tungsten (W), tungsten nitride (WN), and carbon (C). In some cases, the first and second electrodes 110 and 120 may include the same material, or different materials, or the same and different materials; example embodiments are not limited thereto.

In some cases, third electrode 130 may be arranged between the self-selecting memory layer 140 and the resistive memory layer 150. In some example embodiments, the third electrode 1430 may be in a middle between the first and second electrodes 110 and 120; however, example embodiments are not limited thereto. The self-selecting memory layer 140 and the resistive memory layer 150 may be electrically connected to each other in a serial structure. The third electrode 130 may also function as a diffusion and oxidation prevention (or diffusion and oxygen reduction) layer. For this purpose, the third electrode 130 may include, for example, a carbon-based conductive material (e.g., carbon nitride). However, example embodiments are not limited thereto.

The first electrode 110, the self-selecting memory layer 140, and the third electrode 130 may constitute (or correspond to, or be included in) a self-selecting memory device SSM. In some cases, the third electrode 130, the resistive memory layer 150, and the second electrode 120 may constitute (or correspond to, or be included in) a resistive memory device (resistive random access memory device) ReRAM. For example, the memory device 100 according to various embodiments may have a structure in which the self-selecting memory device SSM and the resistive memory device ReRAM are connected in series to each other.

The self-selecting memory layer 140 may have an ovonic threshold switching (OTS) characteristic having a high-resistance state when a voltage lower than a threshold voltage thereof is applied thereto and having a low-resistance state when a voltage higher than the threshold voltage is applied thereto. In some cases, the self-selecting memory layer 140 may have a memory characteristic in which the threshold voltage shifts according to the polarity of, and the strength of (e.g. the absolute value of) a bias voltage applied thereto. Thus, the self-selecting memory layer 140 may have a characteristic of performing both a memory function and a selector function.

The self-selecting memory layer 140 may include a chalcogenide-based material. For example, the self-selecting memory layer 140 may include a chalcogen element including at least one of Se, Te, and S, and at least one of Ge, As, and Sb. The self-selecting memory layer 140 may further include at least one of In, Al, C, B, Sr, Ga, O, N, Si, Ca, and P. For example, the self-selecting memory layer 140 may include at least one of GeAsSe, GeAsSeln, GeAsSeSIn, GeAsSeSb, GeAsSeTe, GeAsSeAl, GeAsSeAlln, GeSbSe, GeAsSeGa, GeSe, GeSeln, GeS, GeSIn, GeCTe, GeCTeN, and GeSbSeN.

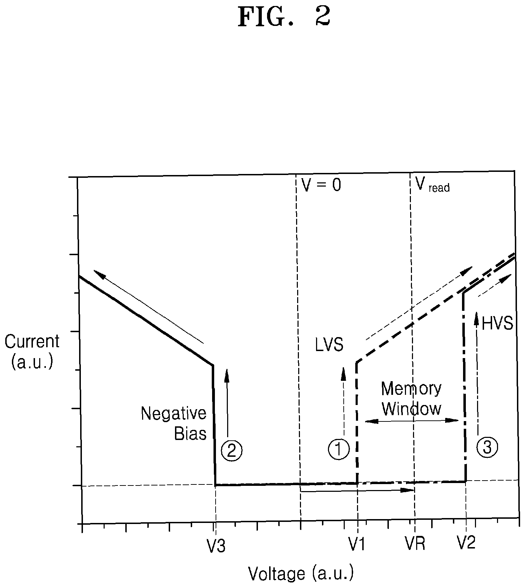

FIG. 2 is a graph illustrating a voltage-current characteristic of the self-selecting memory layer 140 illustrated in FIG. 1.

Referring to FIG. 2, the self-selecting memory layer 140 may have any one of a first state (e.g., a low Vth state (LVS)) in which the threshold voltage is relatively low and a second state (e.g., a high Vth state (HVS)) in which the threshold voltage is relatively high. For example, in the first state, the threshold voltage of the self-selecting memory layer 140 may be a first voltage V1, and in the second state, the threshold voltage of the self-selecting memory layer 140 may be a second voltage V2 higher than (higher in absolute value than) the first voltage V1.

In a case where the self-selecting memory layer 140 is in the first state, when a voltage lower than the first voltage V1 is applied to the self-selecting memory layer 140, almost no current may flow between both ends of the self-selecting memory layer 140, and when a voltage higher than the first voltage V1 is applied to the self-selecting memory layer 140, the self-selecting memory layer 140 may be turned on and thus a current may flow through the self-selecting memory layer 140. In some examples, in a case where the self-selecting memory layer 140 is in the second state, when a voltage lower than the second voltage V2 is applied to the self-selecting memory layer 140, almost no current may flow between both ends of the self-selecting memory layer 140, and when a voltage higher than the second voltage V2 is applied to the self-selecting memory layer 140, the self-selecting memory layer 140 may be turned on and thus a current may flow through the self-selecting memory layer 140.

Thus, a voltage between the first voltage V1 and the second voltage V2 may be selected as a read voltage VR. In a case where the self-selecting memory layer 140 is in the first state, when the read voltage VR is applied to the self-selecting memory layer 140, a current may flow through the self-selecting memory layer 140, and in this case, a data value stored in the self-selecting memory layer 140 may be defined as a first logic value, e.g., as a logic "1". In a case where the self-selecting memory layer 140 is in the second state, when the read voltage VR is applied to the self-selecting memory layer 140, almost no current may flow through the self-selecting memory layer 140, and in this case, a data value stored in the self-selecting memory layer 140 may be defined as a second logic value, e.g., as a logic "0". In some example embodiments, when a current flowing through the self-selecting memory layer 140 is measured while the read voltage VR is applied to the self-selecting memory layer 140, a data value stored in the self-selecting memory layer 140 may be read. In some example embodiments, VR may be half-way between V1 and V2; however, example embodiments are not limited thereto, and VR may be greater than the half-way point between V1 and V2 or less than the half-way point between V1 and V2.

Moreover, in a case where the self-selecting memory layer 140 is in the first state, when a negative (-) bias voltage is applied to the self-selecting memory layer 140, the threshold voltage of the self-selecting memory layer 140 may increase and thus the self-selecting memory layer 140 may be converted into the second state. For example, when a negative third voltage V3 is applied to the self-selecting memory layer 140, the self-selecting memory layer 140 may be converted into the second state. This operation may be referred to as a 'RESET' operation. Alternatively or additionally, in a case where the self-selecting memory layer 140 is in the second state, when a positive (+) bias voltage higher than the second voltage V2 is applied to the self-selecting memory layer 140, the threshold voltage of the self-selecting memory layer 140 may decrease and thus the self-selecting memory layer 140 may be converted into the first state. This operation may be referred to as a 'SET' operation. The difference between the second voltage V2 that is a RESET threshold voltage and the first voltage V1 that is a SET threshold voltage may correspond to or be referred to as a memory window.

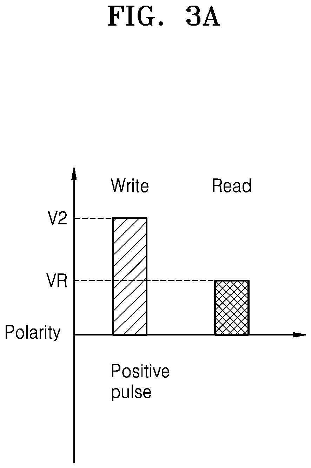

FIG. 3A is a graph illustrating bias voltages for a SET operation and a read operation applied to the self-selecting memory layer 140 illustrated in FIG. 1.

Referring to FIG. 3A, in the SET operation, a positive (+) bias voltage higher than a second voltage V2 may be applied to the self-selecting memory layer 140. Then, the threshold voltage of the self-selecting memory layer 140 may be shifted to the first voltage V1. Thereafter, in the read operation, a positive (+) read voltage VR between the first voltage V1 and the second voltage V2 (e.g., halfway between V1 and V2) may be applied to the self-selecting memory layer 140. When the read voltage VR is applied thereto, the self-selecting memory layer 140 may be turned on.

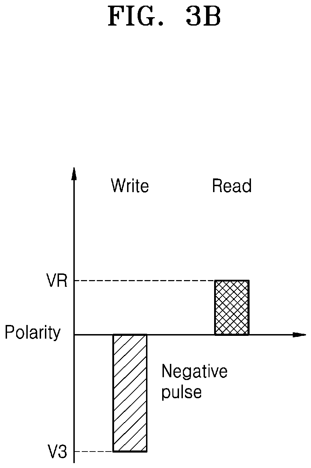

FIG. 3B is a graph illustrating bias voltages for a RESET operation and a read operation applied to the self-selecting memory layer 140 illustrated in FIG. 1.

Referring to FIG. 3B, in the RESET operation, a negative (-) bias voltage, for example, the third voltage V3, may be applied to the self-selecting memory layer 140. The absolute value of the third voltage V3 may be substantially equal to or slightly greater or less than the (absolute value of) the second voltage V2. Then, the threshold voltage of the self-selecting memory layer 140 may be shifted to the second voltage V2 higher than the first voltage V1. Thereafter, in the read operation, a positive (+) read voltage VR between the first voltage V1 and the second voltage V2 may be applied to the self-selecting memory layer 140. When the read voltage VR is applied thereto, the self-selecting memory layer 140 may not be turned on.

As described above, the self-selecting memory layer 140 may simultaneously have an OTS characteristic and a memory characteristic in which the threshold voltage changes. In particular, the threshold voltage of the self-selecting memory layer 140 may be shifted according to the polarity of a bias voltage applied to the self-selecting memory layer 140.

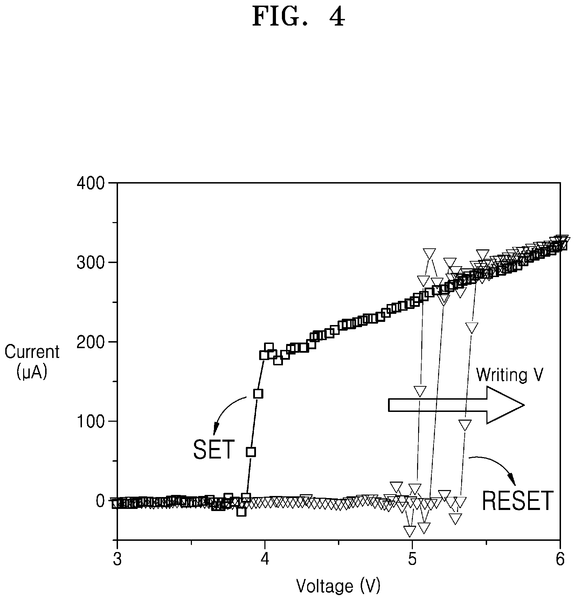

FIG. 4 is a graph illustrating a voltage-current characteristic depending on the magnitude or absolute value of (strength) of a write voltage applied to the self-selecting memory layer 140 illustrated in FIG. 1.

Referring to FIG. 4, when a write voltage applied to the self-selecting memory layer 140 is a voltage of positive (+) polarity, the SET threshold voltage may not change even when the magnitude (strength) of the voltage increases. On the contrary, when a write voltage applied to the self-selecting memory layer 140 is a voltage of negative (-) polarity, the RESET threshold voltage may increase as the magnitude (strength) of the voltage increases. Accordingly, by changing the magnitude of the voltage of negative (-) polarity, a multi-level memory may be implemented in the self-selecting memory layer 140, and in some cases a single (physical) memory cell may store more than one single bit, e.g., 2 or more bits, of information. This may help improve integration density of memory devices.

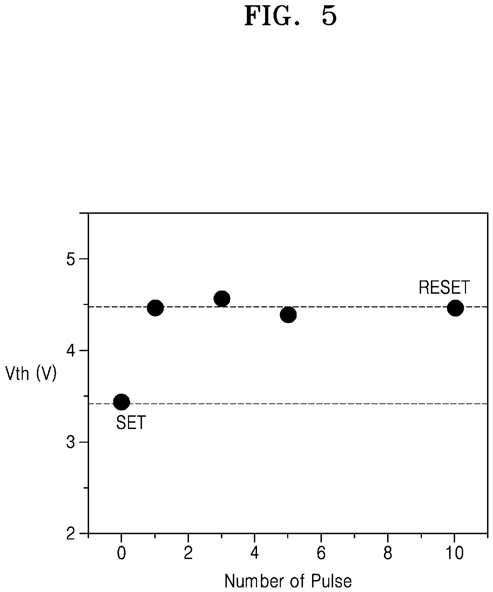

FIG. 5 illustrates a change in threshold voltage (Vth) depending on the number of pulses of a write voltage applied to the self-selecting memory layer 140 illustrated in FIG. 1.

Referring to FIG. 5, when a write voltage applied to the self-selecting memory layer 140 is a pulse voltage of positive (+) polarity, the SET threshold voltage may not change even when the number of pulses increases. Alternatively or additionally, when a write voltage applied to the self-selecting memory layer 140 is a voltage of negative (-) polarity, the RESET threshold voltage may not increase as the number of pulses increases.

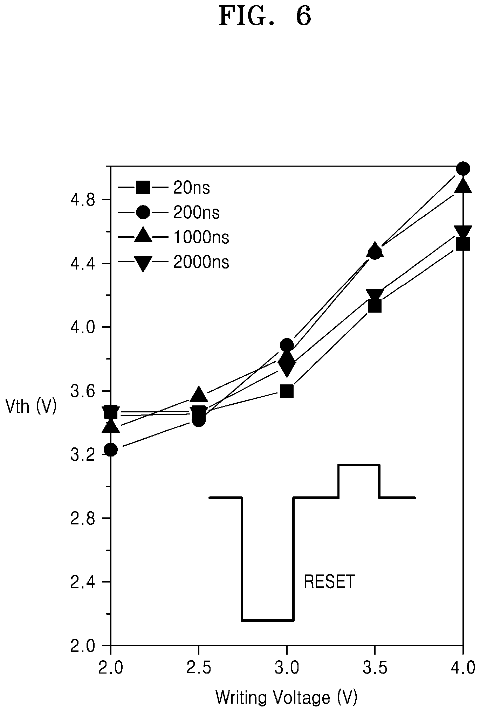

FIG. 6 illustrates a change in threshold voltage (Vth) depending on the pulse width (pulse time) of a write voltage in a RESET operation of the self-selecting memory layer 140 illustrated in FIG. 1. FIG. 6 illustrates a change in threshold voltage depending on the pulse height (pulse amplitude) of a write voltage when the pulse width is 20 ns, 200 ns, 1000 ns, or 2000 ns.

Referring to FIG. 6, the threshold voltage may increase as the pulse height of the write voltage increases, but the threshold voltage may hardly change even when the pulse width of the write voltage increases.

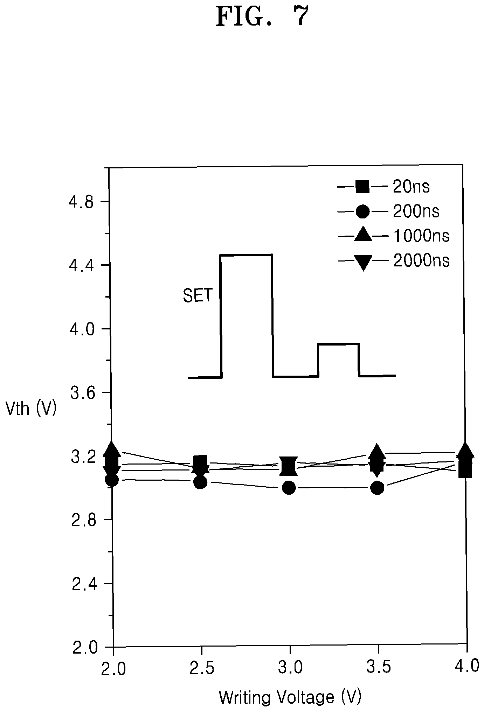

FIG. 7 illustrates a change in threshold voltage (Vth) depending on the pulse width of a write voltage in a SET operation of the self-selecting memory layer 140 illustrated in FIG. 1. FIG. 7 illustrates a change in threshold voltage depending on the pulse height of a write voltage when the pulse width is 20 ns, 200 ns, 1000 ns, or 2000 ns.

Referring to FIG. 7, the threshold voltage may not change even when the pulse height of the write voltage increases, and the threshold voltage may hardly change even when the pulse width of the write voltage increases.

As described above, in the self-selecting memory layer 140, when the write voltage is a pulse voltage of positive (+) polarity, the threshold voltage may not change even when any one or more of the pulse height, the number of pulses, and the pulse width change. Alternatively or additionally, when the write voltage is a pulse voltage of negative (-) polarity, the threshold voltage may change when the pulse height changes but the threshold voltage may not change even when the number of pulses and/or the pulse width change. Thus, when a pulse voltage of negative (-) polarity is applied as the write voltage to the self-selecting memory layer 140 and the pulse height of the applied voltage changes, the resistance state of the self-selecting memory layer 140 may change.

Referring back to FIG. 1, the resistive memory layer 150 may be arranged between the second electrode 120 and the third electrode 130. The resistive memory layer 150 may include a material of which the resistance characteristic changes depending on a voltage applied thereto. The resistive memory layer 150 may include, for example, one or, more of Al₂O₃, In₂O₃, MgO, MoO₃, Ta₂O₅, HfO₂, PrCaMnO₃, TiO₂, V₂O₅, or ZnO. However, this is only an example.

The resistance characteristic of the resistive memory layer 150 may depend on whether a conductive filament is formed by the behavior of oxygen in the resistive memory layer 150 according to the applied voltage. In some cases, when a certain voltage is applied to the resistive memory layer 150, oxygen vacancies may be formed in the resistive memory layer 150 and the formed oxygen vacancies may be collected to form a conductive filament. The resistance of the resistive memory layer 150 may be lowered by the formation of the conductive filament. For example, the resistive memory layer 150 may change from a high resistive state (HRS) to a low resistive state (LRS).

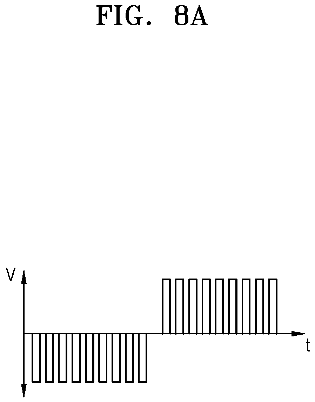

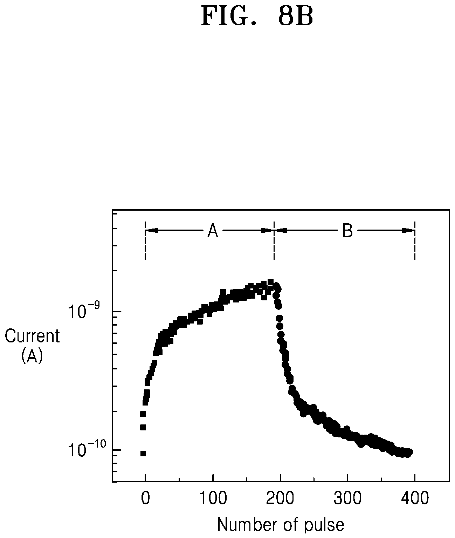

FIGS. 8A and 8B are graphs illustrating a current characteristic depending on the number of pulses of a write voltage applied to the resistive memory layer 150 illustrated in FIG. 1. In FIG. 8B, "A" represents a current characteristic corresponding to the voltage pulses of negative (-) polarity illustrated in FIG. 8A, and "B" represents a current characteristic corresponding to the voltage pulses of positive (+) polarity illustrated in FIG. 8A.

FIG. 8A illustrates voltage pulses of negative (-) polarity and voltage pulses of positive (+) polarity that are applied over time (t) to the resistive memory layer 150 illustrated in FIG. 1. Here, the voltage pulses may have the same pulse height (or absolute value of magnitude) and the same pulse width. In some cases, a duty cycle of a pulse train may be 1:1; however, example embodiments are not limited thereto, and the duty cycle of the pulse train may be less than or greater than 1:1. FIG. 8B illustrates a current characteristic in a case where the voltage pulses illustrated in FIG. 8A are applied to the resistive memory layer 150 illustrated in FIG. 1. Referring to FIGS. 8A and 8B, the resistance state of the resistive memory layer 150 may change depending on the number of pulses applied to the resistive memory layer 150. Particularly, as the number of voltage pulses of negative (-) polarity increases, the resistance may gradually increase, and as the number of voltage pulses of positive (+) polarity increases, the resistance may gradually decrease.

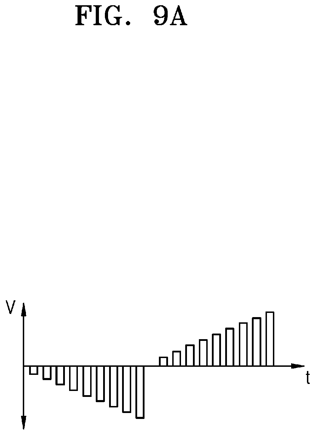

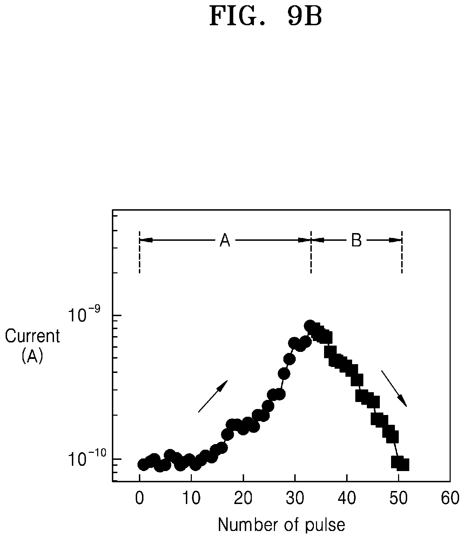

FIGS. 9A and 9B are graphs illustrating a current characteristic depending on the pulse height of a write voltage applied to the resistive memory layer 150 illustrated in FIG. 1. In FIG. 9B, "A" represents a current characteristic corresponding to the voltage pulses of negative (-) polarity illustrated in FIG. 9A, and "B" represents a current characteristic corresponding to the voltage pulses of positive (+) polarity illustrated in FIG. 9A.

FIG. 9A illustrates voltage pulses of negative (-) polarity and voltage pulses of positive (+) polarity that are applied over time (t) to the resistive memory layer 150 illustrated in FIG. 1. Here, the voltage pulses may have the same pulse width and may have a pulse height that increases (e.g., increases linearly and/or in a concave and/or convex manner) over time. FIG. 9B illustrates a current characteristic in a case where the voltage pulses illustrated in FIG. 9A are applied to the resistive memory layer 150 illustrated in FIG. 1. Referring to FIGS. 9A and 9B, the resistance state of the resistive memory layer 150 may change depending on the pulse height applied to the resistive memory layer 150. Particularly, as the number of voltage pulses of negative (-) polarity increases, the resistance may gradually increase, and as the number of voltage pulses of positive (+) polarity increases, the resistance may gradually decrease. Referring to FIGS. 8B and 9B in comparison with each other, the degree of change in resistance as the number of pulses having a gradually increasing pulse height increases may change more linearly than the degree of change in resistance as the number of pulses having the same pulse height increases.

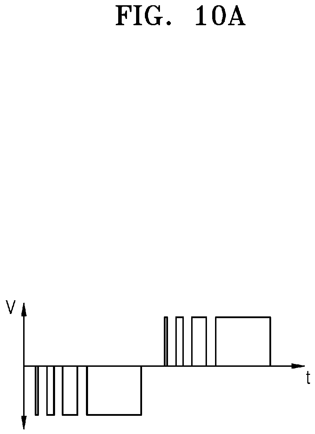

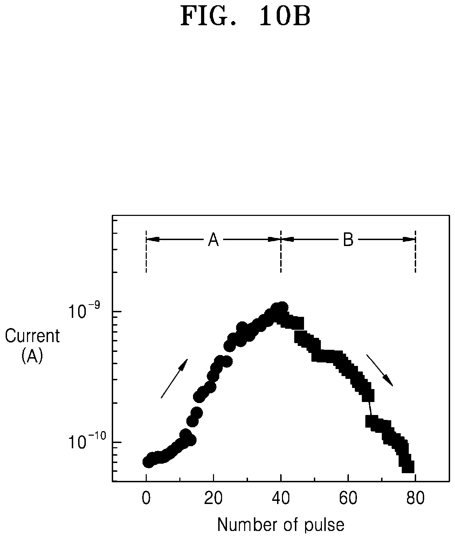

FIGS. 10A and 10B are graphs illustrating a current characteristic depending on the pulse width of a write voltage applied to the resistive memory layer 150 illustrated in FIG. 1. In FIG. 10B, "A" represents a current characteristic corresponding to the voltage pulses of negative (-) polarity illustrated in FIG. 10A, and "B" represents a current characteristic corresponding to the voltage pulses of positive (+) polarity illustrated in FIG. 10A.

FIG. 10A illustrates voltage pulses of negative (-) polarity and voltage pulses of positive (+) polarity that are applied over time (t) to the resistive memory layer 150 illustrated in FIG. 1. Here, the voltage pulses may have the same pulse height and may have a pulse width that changes, e.g., that increases over time. FIG. 10B illustrates a current characteristic in a case where the voltage pulses illustrated in FIG. 10A are applied to the resistive memory layer 150 illustrated in FIG. 1. Referring to FIGS. 10A and 10B, the resistance state of the resistive memory layer 150 may change depending on the pulse width applied to the resistive memory layer 150. Particularly, as the number of voltage pulses of negative (-) polarity increases, the resistance may gradually increase, and as the number of voltage pulses of positive (+) polarity increases, the resistance may gradually decrease. Referring to FIGS. 8B and 10B in comparison with each other, the degree of change in resistance as the number of pulses having a gradually increasing pulse width increases may change more linearly than the degree of change in resistance as the number of pulses having the same pulse width increases.

As described above, in the resistive memory layer 150, when the write voltage is a pulse voltage of positive (+) polarity, the resistance state of the resistive memory layer 150 may change when the pulse height, number of pulses, and pulse width change. Alternatively or additionally, when the write voltage is a pulse voltage of negative (-) polarity, the resistance state of the resistive memory layer 150 may change when the pulse height, number of pulses, and pulse width change.

As described above, the memory device 100 according to some example embodiments may have a structure in which the self-selecting memory layer 140 and the resistive memory layer 150 are connected in series to each other. Thus, the resistance of the memory device 100 may be determined by the sum of the resistance of the self-selecting memory layer 140 and the resistance of the resistive memory layer 150. Hereinafter, a method of implementing a multi-level memory by using the above memory device 100 will be described.

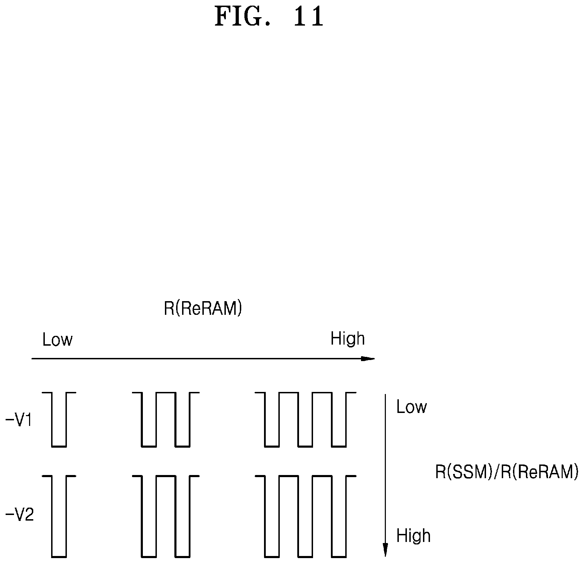

FIG. 11 schematically illustrates a change in resistance depending on the pulse height and the number of pulses of a write voltage applied to the memory device 100 illustrated in FIG. 1. FIG. 11 illustrates a case where a pulse voltage of negative (-) polarity is used as a write voltage between the first and second electrodes 110 and 120 of the memory device 100 illustrated in FIG. 1. In FIG. 11, "R(SSM)" represents the resistance of the self-selecting memory layer 140, and "R(ReRAM)" represents the resistance of the resistive memory layer 150.

Referring to FIG. 11, as the pulse height increases, the resistance R(SSM) of the self-selecting memory layer 140 and the resistance R(ReRAM) of the resistive memory layer 150 may increase. Also, as the number of pulses increases, the resistance R(SSM) of the self-selecting memory layer 140 may be constant but the resistance R(ReRAM) of the resistive memory layer 150 may increase.

Table 1 illustrates resistance states that may be implemented according to the pulse height and the number of pulses when a pulse voltage of negative (-) polarity is applied between the first and second electrodes 110 and 120 of the memory device 100 illustrated in FIG. 1.

Table 1 describes resistance states that may be implemented when the pulse heights are V1, V2, and V3 (where V1<V2<V3), and the numbers of pulses are 1, 2, and 3 for the respective pulse heights.

**[Table 1]**

| **Pulse height (Reset V)** | **R** | **single pulse** | **double pulse** | **triple pulse** |
|---|---|---|---|---|
| -V1 | R(SSM) | R(S1) | R(S1) | R(S1) |
| | R(ReRAM) | R(O11) | R(O12) | R(O13) |
| -V2 | R(SSM) | R(S2) | R(S2) | R(S2) |
| | R(ReRAM) | R(O21) | R(O22) | R(O23) |
| -V3 | R(SSM) | R(S3) | R(S3) | R(S3) |
| | R(ReRAM) | R(O31) | R(O32) | R(O33) |

Referring to Table 1, in a case where the pulse height is V1, as the number of pulses increases to 1, 2, and 3, the resistance R(SSM) of the self-selecting memory layer 140 may all be constant as R(S1) and the resistance R(ReRAM) of the resistive memory layer 150 may change to R(O11), R(O12), and R(O13) (where R(O11)<R(O12)<R(O13)). Accordingly, in a case where the pulse height is V1, when the number of pulses changes to 1, 2, and 3, the memory device 100 may implement three resistance states, that is, R(S1)+R(O11), R(S1)+R(O12), and R(S1)+R(O13).

In a case where the pulse height is V2 (>V1), as the number of pulses increases to 1, 2, and 3, the resistance R(SSM) of the self-selecting memory layer 140 may all be constant as R(S2) (>R(S1)) and the resistance R(ReRAM) of the resistive memory layer 150 may change to R(O21), R(O22), and R(O23) (where R(O21)<R(O22)<R(O23)). Accordingly, in a case where the pulse height is V2, when the number of pulses changes to 1, 2, and 3, the memory device 100 may implement three resistance states, that is, R(S2)+R(O21), R(S2)+R(O22), and R(S2)+R(O23).

In a case where the pulse height is V3 (>V2), as the number of pulses increases to 1, 2, and 3, the resistance R(SSM) of the self-selecting memory layer 140 may all be constant as R(S3) (>R(S2)) and the resistance R(ReRAM) of the resistive memory layer 150 may change to R(O31), R(O32), and R(O33) (where R(O31)<R(O32)<R(O33)). Accordingly, in a case where the pulse height is V3, when the number of pulses changes to 1, 2, and 3, the memory device 100 may implement three resistance states, that is, R(S3)+R(O31), R(S3)+R(O32), and R(S3)+R(O33).

As described above, in a case where a pulse voltage of negative (-) polarity is applied as a write voltage between the first and second electrodes 110 and 120 of the memory device 100, when three pulse heights and three pulses are used, the memory device 100 may implement up to nine-level resistance states. Thus, when "n" pulse heights and "m" pulses are used, the memory device 100 may implement up to (n×m) resistance states.

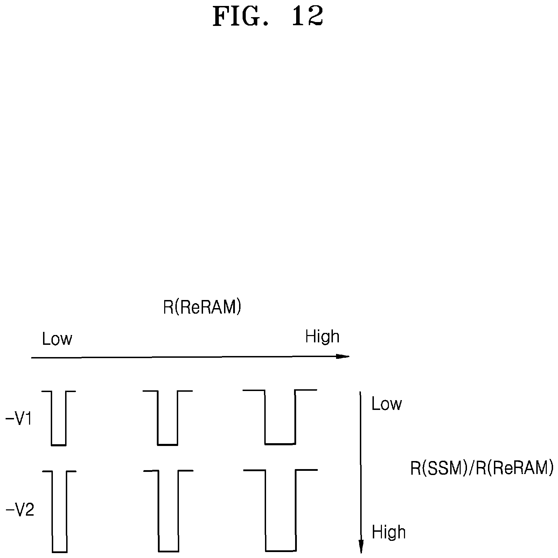

FIG. 12 schematically illustrates a change in resistance depending on the pulse height and pulse width of a write voltage applied to the memory device 100 illustrated in FIG. 1. FIG. 12 illustrates a case where a pulse voltage of negative (-) polarity is used as a write voltage between the first and second electrodes 110 and 120 of the memory device 100 illustrated in FIG. 1.

Referring to FIG. 12, as described above, as the pulse height increases, the resistance R(SSM) of the self-selecting memory layer 140 and the resistance R(ReRAM) of the resistive memory layer 150 may increase. Also, as the pulse width increases, the resistance R(SSM) of the self-selecting memory layer 140 may be constant but the resistance R(ReRAM) of the resistive memory layer 150 may increase.

Table 2 illustrates resistance states that may be implemented according to the pulse height and the pulse width when a pulse voltage of negative (-) polarity is applied between the first and second electrodes 110 and 120 of the memory device 100 illustrated in FIG. 1.

Table 2 describes resistance states that may be implemented when the pulse heights are V1, V2, and V3 (where V1<V2<V3), and the pulse widths are W1, W2, and W3 (where W1<W2<W3) for the respective pulse heights.

**[Table 2]**

| **Pulse height (Reset V)** | **R** | **pulse width(W1)** | **pulse width(W2)** | **pulse width(W3)** |
|---|---|---|---|---|
| -V1 | R(SSM) | R(S1) | R(S1) | R(S1) |
| | R(ReRAM) | R(O14) | R(O15) | R(O16) |
| -V2 | R(SSM) | R(S2) | R(S2) | R(S2) |
| | R(ReRAM) | R(O24) | R(O25) | R(O26) |
| -V3 | R(SSM) | R(S3) | R(S3) | R(S3) |
| | R(ReRAM) | R(O34) | R(O35) | R(O36) |

Referring to Table 2, in a case where the pulse height is V1, as the pulse width increases to W1, W2, and W3, the resistance R(SSM) of the self-selecting memory layer 140 may all be constant as R(S1) and the resistance R(ReRAM) of the resistive memory layer 150 may change to R(O14), R(O15), and R(O16) (where R(O14)<R(O15)<R(O16)). Accordingly, in a case where the pulse height is V1, when the pulse width changes to W1, W2, and W3, the memory device 100 may implement three resistance states, that is, R(S1)+R(O14), R(S1)+R(O15), and R(S1)+R(O16).

In a case where the pulse height is V2 (>V1), as the pulse width increases to W1, W2, and W3, the resistance R(SSM) of the self-selecting memory layer 140 may all be constant as R(S2) (>R(S1)) and the resistance R(ReRAM) of the resistive memory layer 150 may change to R(O24), R(O25), and R(O26) (where R(O24)<R(O25)<R(O26)). Accordingly, in a case where the pulse height is V2, when the pulse width changes to W1, W2, and W3, the memory device 100 may implement three resistance states, that is, R(S2)+R(O24), R(S2)+R(O25), and R(S2)+R(O26).

In a case where the pulse height is V3 (>V2), as the pulse width increases to W1, W2, and W3, the resistance R(SSM) of the self-selecting memory layer 140 may all be constant as R(S3) (>R(S2)) and the resistance R(ReRAM) of the resistive memory layer 150 may change to R(O34), R(O35), and R(O36) (where R(O34)<R(O35)<R(O36)). Accordingly, in a case where the pulse height is V3, when the pulse width changes to W1, W2, and W3, the memory device 100 may implement three resistance states, that is, R(S3)+R(O34), R(S3)+R(O35), and R(S3)+R(O36).

As described above, in a case where a pulse voltage of negative (-) polarity is applied as a write voltage between the first and second electrodes 110 and 120 of the memory device 100, when three pulse heights and three pulse widths are used, the memory device 100 may implement up to nine-level resistance states. Thus, when "n" pulse heights and "m" pulse widths are used, the memory device 100 may implement up to (n×m) resistance states. Here, "m" may be less than, equal to, or greater than "n".

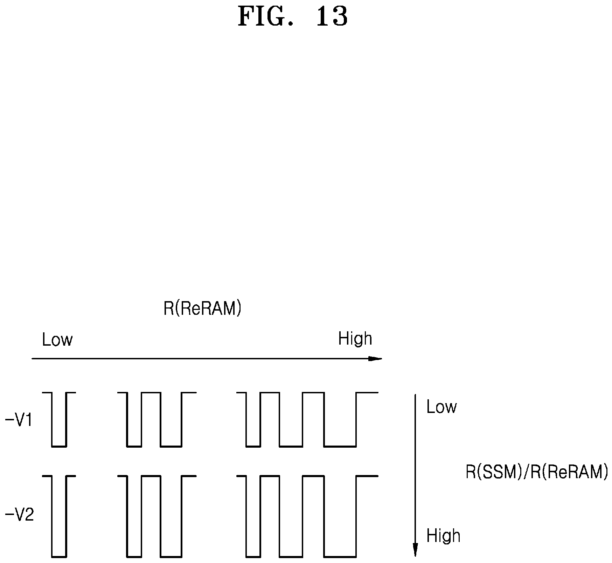

FIG. 13 schematically illustrates a change in resistance depending on the pulse height, number of pulses, and pulse width of a write voltage applied to the memory device 100 illustrated in FIG. 1. FIG. 13 illustrates a case where a pulse voltage of negative (-) polarity is used as a write voltage between the first and second electrodes 110 and 120 of the memory device 100 illustrated in FIG. 1.

Referring to FIG. 13, as described above, as the pulse height increases, the resistance R(SSM) of the self-selecting memory layer 140 and the resistance R(ReRAM) of the resistive memory layer 150 may increase. Also, as the number of pulses/the pulse width increases, the resistance R(SSM) of the self-selecting memory layer 140 may be constant but the resistance R(ReRAM) of the resistive memory layer 150 may increase.

Table 3 illustrates resistance states that may be implemented according to the pulse height and the pulse width when a pulse voltage of negative (-) polarity is applied between the first and second electrodes 110 and 120 of the memory device 100 illustrated in FIG. 1.

Table 3 describes resistance states that may be implemented when the pulse heights are V1, V2, and V3 (where V1<V2<V3), and the numbers of pulses/the pulse widths are 1/W1, 2/W2, and 3/W3 for the respective pulse heights.

**[Table 3]**

| **Pulse height (Reset V)** | **R** | **single pulse / pulse width(W1)** | **double pulse / pulse width(W2)** | **triple pulse / pulse width(W3)** |
|---|---|---|---|---|
| -V1 | R(SSM) | R(S1) | R(S1) | R(S1) |
| | R(ReRAM) | R(O17) | R(O18) | R(O19) |
| -V2 | R(SSM) | R(S2) | R(S2) | R(S2) |
| | R(ReRAM) | R(O27) | R(O28) | R(O29) |
| -V3 | R(SSM) | R(S3) | R(S3) | R(S3) |
| | R(ReRAM) | R(O37) | R(O38) | R(O39) |

Referring to Table 3, in a case where the pulse height is V1, as the number of pulses/the pulse width increases to 1/W1, 2/W2, and 3/W3, the resistance R(SSM) of the self-selecting memory layer 140 may all be constant as R(S1) and the resistance R(ReRAM) of the resistive memory layer 150 may change to R(O17), R(O18), and R(O19) (where R(O17)<R(O18)<R(O19)). Accordingly, in a case where the pulse height is V1, when the number of pulses/the pulse width changes to 1/W1, 2/W2, and 3/W3, the memory device 100 may implement three resistance states, that is, R(S1)+R(O17), R(S1)+R(O18), and R(S1)+R(O19).

In a case where the pulse height is V2 (>V1), as the number of pulses/the pulse width increases to 1/W1, 2/W2, and 3/W3, the resistance R(SSM) of the self-selecting memory layer 140 may all be constant as R(S2) (>R(S1)) and the resistance R(ReRAM) of the resistive memory layer 150 may change to R(O27), R(O28), and R(O29) (where R(O27)<R(O28)<R(O29)). Accordingly, in a case where the pulse height is V2, when the number of pulses/the pulse width changes to 1/W1, 2/W2, and 3/W3, the memory device 100 may implement three resistance states, that is, R(S2)+R(O27), R(S2)+R(O28), and R(S2)+R(O29).

In a case where the pulse height is V3 (>V2), as the number of pulses/the pulse width increases to 1/W1, 2/W2, and 3/W3, the resistance R(SSM) of the self-selecting memory layer 140 may all be constant as R(S3) (>R(S2)) and the resistance R(ReRAM) of the resistive memory layer 150 may change to R(O37), R(O38), and R(O39) (where R(O37)<R(O38)<R(O39)). Accordingly, in a case where the pulse height is V3, when the number of pulses/the pulse width changes to 1/W1, 2/W2, and 3/W3, the memory device 100 may implement three resistance states, that is, R(S3)+R(O37), R(S3)+R(O38), and R(S3)+R(O39).

As described above, in a case where a pulse voltage of negative (-) polarity is applied as a write voltage between the first and second electrodes 110 and 120 of the memory device 100, when three pulse heights and three pulses/pulse widths are used, the memory device 100 may implement up to nine-level resistance states. Thus, when "n" pulse heights and "m" pulses/pulse widths are used, the memory device 100 may implement up to (n×m) resistance states. Here, "n" may be less than, equal to, or greater than "m".

A case where the memory device 100 implements multi-level resistance states when a pulse voltage of negative (-) polarity is applied between the first and second electrodes 110 and 120 of the memory device 100 has been described above. However, example embodiments are not limited thereto, and multi-level resistance states may also be implemented by applying a pulse voltage of positive (+) polarity between the first and second electrodes 110 and 120 of the memory device 100.

Table 4 illustrates resistance states that may be implemented according to the pulse height and the number of pulses when a pulse voltage of positive (+) polarity is applied between the first and second electrodes 110 and 120 of the memory device 100 illustrated in FIG. 1.

**[Table 4]**

| **Pulse height (Reset V)** | **R** | **single pulse** | **double pulse** | **triple pulse** |
|---|---|---|---|---|
| +V1' | R(SSM) | R(S0') | R(S0') | R(S0') |
| | R(ReRAM) | R(O11') | R(O12') | R(O13') |
| +V2' | R(SSM) | R(S0') | R(S0') | R(S0') |
| | R(ReRAM) | R(O21') | R(O22') | R(O23') |
| +V3' | R(SSM) | R(S0') | R(S0') | R(S0') |
| | R(ReRAM) | R(O31') | R(O32') | R(O33') |

Referring to Table 4, even when the pulse height changes to V1', V2', and V3' and the number of pulses increases to 1, 2, and 3, the resistance R(SSM) of the self-selecting memory layer 140 may all be constant as R(S0'). In a case where the pulse height is V1', when the pulse number changes to 1, 2, and 3, the resistance R(ReRAM) of the resistive memory layer 150 may change to R(O11'), R(O12'), and R(O13'). In a case where the pulse height is V2', when the number of pulses changes to 1, 2, and 3, the resistance R(ReRAM) of the resistive memory layer 150 may change to R(O21'), R(O22'), and R(O23'). Also, in a case where the pulse height is V3', when the number of pulses changes to 1, 2, and 3, the resistance R(ReRAM) of the resistive memory layer 150 may change to R(O31'), R(O32'), and R(O33').

As described above, in a case where a pulse voltage of positive (+) polarity is applied as a write voltage between the first and second electrodes 110 and 120 of the memory device 100, when three pulse heights and three pulses are used, the memory device 100 may implement up to nine-level resistance states. Similarly, in a case where a pulse voltage of positive (+) polarity is applied as a write voltage between the first and second electrodes 110 and 120 of the memory device 100, multi-level resistance states may be implemented even when a plurality of pulse widths are used.

In the memory device 100 according to some example embodiments, multi-level resistance states may be implemented by adjusting the resistance of the self-selecting memory layer 140 and the resistance of the resistive memory layer 150 by using at least one of the pulse polarity, pulse size, number of pulses, and pulse width of a write voltage applied between the first and second electrodes 110 and 120.

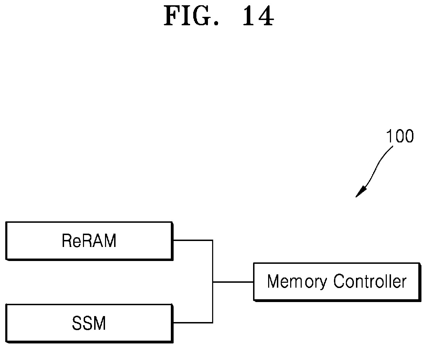

FIG. 14 is a block diagram illustrating a schematic configuration of a memory device 100 according to some example embodiments.

Referring to FIG. 14, the memory device 100 may include a self-selecting memory device SSM, a resistive memory device ReRAM connected in series to the self-selecting memory device SSM, and a memory controller.

As described above, the self-selecting memory device SSM may have an OTS characteristic and may have a threshold voltage varying depending on the polarity and strength of a voltage applied thereto. The resistive memory device ReRAM may have a resistance characteristic varying depending on a voltage applied thereto. The memory controller may implement a multi-level memory by being configured to adjust the resistance of the self-selecting memory device and the resistance of the resistive memory device. For example, the memory controller may adjust the resistance of the self-selecting memory device by changing the height of a pulse voltage of negative (-) polarity applied to the self-selecting memory device. Alternatively or additionally, the memory controller may adjust the resistance of the resistive memory device by changing at least one of the height of the pulse voltage applied to the resistive memory device, the number of pulse voltages, and the width of the pulse voltage.

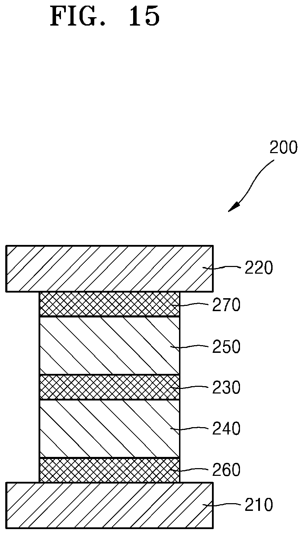

FIG. 15 schematically illustrates a cross-section of a memory device 200 according to some example embodiments. Hereinafter, the differences from the above example embodiments are mainly described.

Referring to FIG. 15, the memory device 200 may include first and second electrodes 210 and 220 arranged apart from each other, and a self-selecting memory layer 240 and a resistive memory layer 250 arranged between the first and second electrodes 210 and 220.

A first insert layer 260 may be arranged between the first electrode 210 and the self-selecting memory layer 240. The first insert layer 260 may prevent the oxidation of the self-selecting memory layer 240 and may include, for example, a carbon-based conductive material (e.g., carbon nitride). However, example embodiments are not limited thereto.

A second insert layer 270 may be arranged between the second electrode 220 and the resistive memory layer 250. The second insert layer 270 may prevent the oxidation or reduction of the resistive memory layer 250 and may include, for example, a conductive oxide or a conductive nitride. For example, the second insert layer 270 may include, but is not limited to, one or more of TiO₂, SnO₂, RuO₂, ITO, IZO, TaN, TiN, WN, or NbN.

A third electrode 230 arranged between the self-selecting memory layer 240 and the resistive memory layer 250 may also function as a diffusion and oxidation prevention layer. The third electrode 230 may include, for example, a carbon-based conductive material (e.g., carbon nitride); however, the disclosure is not limited to.

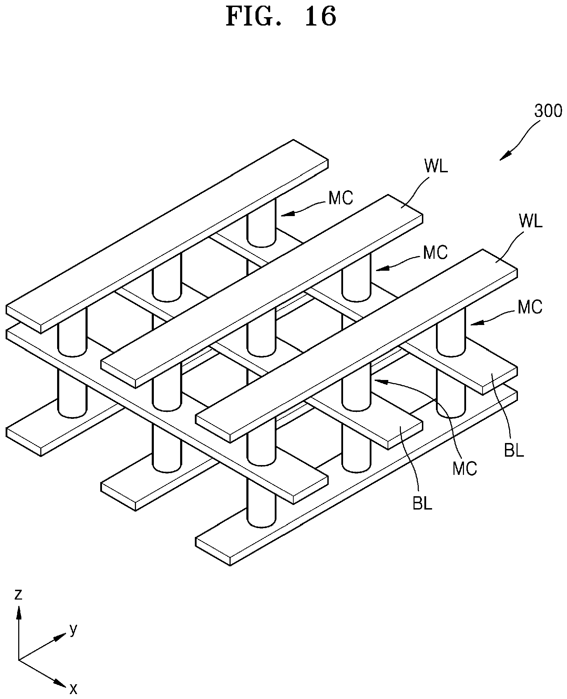

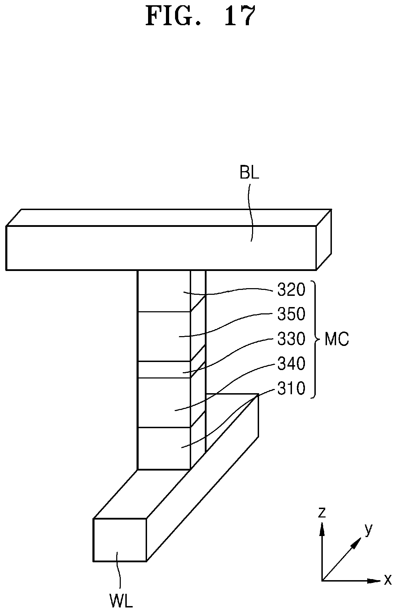

FIG. 16 is a perspective view schematically illustrating a memory device 300 according to some example embodiments. FIG. 17 is an enlarged view of one memory cell MC in the memory device 300 illustrated in FIG. 16.

Referring to FIGS. 16 and 17, the memory device 300 may have a three-dimensional cross-point structure. For example, the memory device 300 may include a plurality of bit lines BL extending in a first direction (i.e., the x-axis direction), a plurality of word lines WL extending in a second direction (i.e., the y-axis direction) intersecting the first direction, and a plurality of memory cells MC arranged at points where the plurality of bit lines BL and the plurality of word lines WL intersect each other.

Each of the plurality of memory cells MC may correspond to the memory device 100 illustrated in FIG. 1. A first electrode 310 and a second electrode 320 may be respectively the same as the first electrode 110 and the second electrode 120 of the memory device 100 illustrated in FIG. 1, and thus, redundant descriptions thereof will be omitted for conciseness. The first electrode 310 and the second electrode 320 may be integrally formed with the word line WL and the bit line BL, respectively.

Between the first and second electrodes 310 and 320, a self-selecting memory layer 340 and a resistive memory layer 350 may be connected to each other in a serial structure. The self-selecting memory layer 340 and the resistive memory layer 350 may be respectively the same as the self-selecting memory layer 140 and the resistive memory layer 150 illustrated in FIG. 1, and thus, redundant descriptions thereof will be omitted for conciseness. A third electrode 330 may be arranged between the self-selecting memory layer 340 and the resistive memory layer 350. Moreover, each of the plurality of memory cells MC may correspond to the memory device 200 illustrated in FIG. 15.

In this structure, the memory cell MC may be driven by the potential difference between a word line WL and a bit line BL connected to both ends of each memory cell MC, and each memory cell MC may implement a multi-level memory by using at least one of the pulse polarity, pulse size, number of pulses, and pulse width of a voltage applied between the word line WL and the bit line BL.

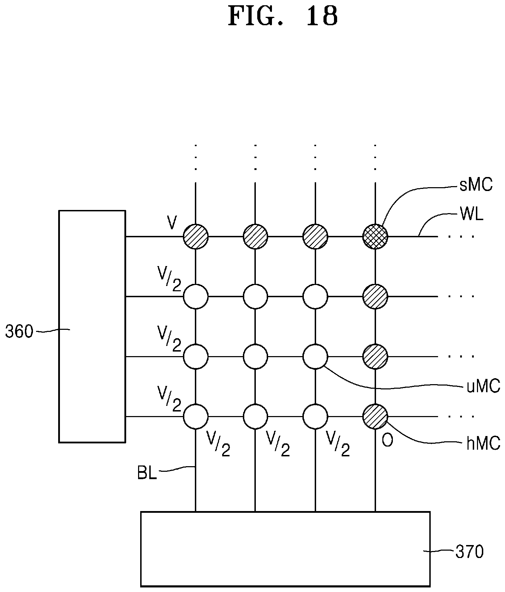

FIG. 18 is a plan view illustrating an operation of selecting a particular memory cell in the memory device 300 illustrated in FIG. 16.

Referring to FIG. 18, the memory device 300 may further include a row decoder 360 configured to selectively supply a voltage to a plurality of word lines WL and a column decoder 370 configured to selectively supply a voltage to a plurality of bit lines BL. When a voltage of V is to be applied to a selected memory cell sMC among a plurality of memory cells MC, the row decoder 360 may provide a voltage of V to a word line WL connected to the selected memory cell sMC and provide a voltage of V/2 to the other word lines WL. In this case, the column decoder 370 may provide a voltage of 0 V to a bit line BL connected to the selected memory cell sMC and provide a voltage of V/2 to the other bit lines BL.

Then, the potential difference between the word line WL and the bit line BL of the selected memory cell sMC may be V. On the other hand, the potential difference between the word line WL provided with a voltage of V/2 and the bit line BL provided with a voltage of V/2 may be 0 V. Thus, no voltage may be applied to an unselected memory cell uMC arranged between a word line WL and a bit line BL that are not connected to the selected memory cell sMC. Moreover, a voltage of V/2 may be applied to both ends of a semi-selected memory cell hMC connected to the same word line WL as the selected memory cell sMC or connected to the same bit line BL as the selected memory cell sMC. Because each of the plurality of memory cells MC is a self-selecting memory device as described above, even when a voltage of V/2 is applied to a semi-selected memory cell hMC adjacent to the selected memory cell sMC, the semi-selected memory cell hMC may not be turned on, and as a result, almost no sneak current may occur.

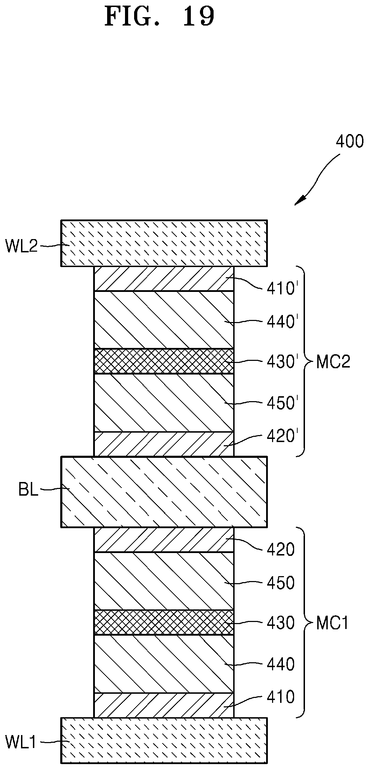

FIG. 19 is a cross-sectional view schematically illustrating a multi-layer memory device 400 according to some example embodiments. The memory device 400 may have a multi-layer structure in which bit lines and word lines alternate vertically with each other. FIG. 19 illustrates a portion of the memory device 400 having a three-dimensional cross-point structure.

Referring to FIG. 19, first and second word lines WL1 and WL2 may be vertically arranged in parallel to each other, and a bit line BL may be arranged between the first and second word lines WL1 and WL2 to intersect the first and second word lines WL1 and WL2. Here, the bit line BL may be a common bit line.

A first memory cell MC1 may be arranged between the first word line WL1 and the bit line BL, and a second memory cell MC2 may be arranged between the second word line WL2 and the bit line BL. Here, each of the first and second memory cells MC1 and MC2 may correspond to the memory device 100 illustrated in FIG. 1. The first/second memory cell MC1/MC2 may have a structure in which a first electrode 410/410', a self-selecting memory layer 440/440', a third electrode 430/430', a resistive memory layer 450/450', and a second electrode 420/420' are sequentially stacked.

The first and second memory cells MC1 and MC2 may be arranged in a symmetrical structure with respect to the bit line BL. Particularly, the first electrode 410 of the first memory cell MC1 and the first electrode 410' of the second memory cell MC2 may be symmetrically arranged with respect to the bit line BL, and the second electrode 420 of the first memory cell MC1 and the second electrode 420' of the second memory cell MC2 may be symmetrically arranged with respect to the bit line BL. The first electrode 410 of the first memory cell MC1 may be integrally formed with the first word line WL1, and the first electrode 410' of the second memory cell MC2 may be integrally formed with the second word line WL2. In some examples, the second electrode 420 of the first memory cell MC1 and the second electrode 420' of the second memory cell MC2 may be integrally formed with the bit line BL. The self-selecting memory layer 440 of the first memory cell MC1 and the self-selecting memory layer 440' of the second memory cell MC2 may be symmetrically arranged with respect to the bit line BL, and the resistive memory layer 450 of the first memory cell MC1 and the resistive memory layer 450' of the second memory cell MC2 may be symmetrically arranged with respect to the bit line BL. Moreover, each of the first and second memory cells MC1 and MC2 may correspond to the memory device 200 illustrated in FIG. 15.

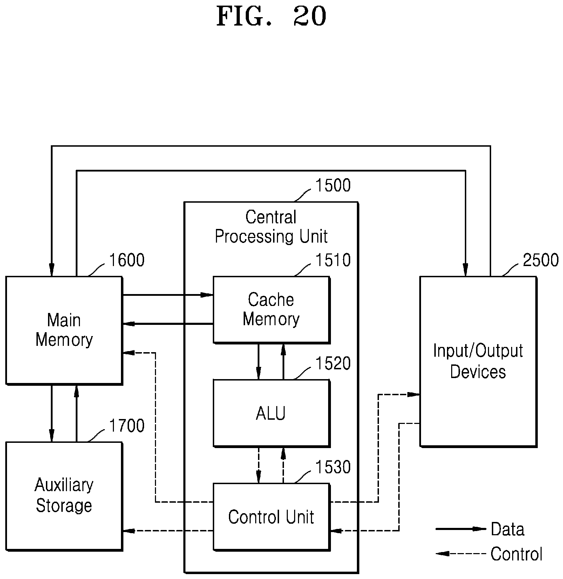

The memory devices 100, 200, 300, and 400 according to variously described embodiments described above may be used for data storage in various electronic apparatuses. FIG. 20 is a conceptual diagram schematically illustrating a device architecture applicable to an electronic apparatus according to embodiments.

Referring to FIG. 20, a cache memory 1510, an arithmetic logic unit (ALU) 1520, and a control unit 1530 may constitute a central processing unit (CPU) 1500, and the cache memory 1510 may include a static random access memory (SRAM). A main memory 1600 and an auxiliary storage 1700 may be provided separately from the CPU 1500. Input/Output Devices 2500 may be provided. The main memory 1600 may include a dynamic random access memory (DRAM) device, and the auxiliary storage 1700 may include the memory devices 100 and 200 described above. In some cases, the device architecture may be implemented in a form in which computing unit devices and memory unit devices are adjacent to each other in one chip without distinction between subunits.

The memory devices 100, 200, 300, and 400 according to the embodiment described above may be implemented as a chip-type memory block to be used as a neuromorphic computing platform or may be used to configure a neural network.

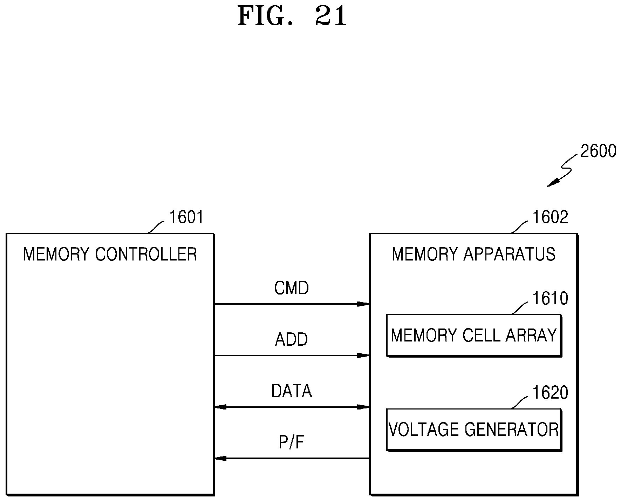

FIG. 21 is a block diagram of a memory system 2600 according to some example embodiments.

Referring to FIG. 21, the memory system 2600 may include a memory controller 1601 and a memory apparatus 1602. The memory controller 1601 may perform a control operation on the memory apparatus 1602, and for example, the memory controller 1601 may provide, to the memory apparatus 1602, an address ADD and a command CMD for performing a program (or write), read, and/or erase operation on the memory apparatus 1602. Also, data for a program operation and read data may be transmitted between the memory controller 1601 and the memory apparatus 1602.

The memory apparatus 1602 may include a memory cell array 1610 and a voltage generator 1620. The memory cell array 1610 may include a plurality of memory cells and may include one or more of the memory devices 100, 200, 300, and 400 according to the embodiments described above.

The memory controller 1601 may include a processing circuit such as hardware including a logic circuit; a hardware/software combination such as processor execution software; or a combination thereof. More particularly, the processing circuit may include, for example, one or more of a CPU, an ALU, a digital signal processor, a microcomputer, a field programmable gate array (FPGA), a system-on-chip (SoC), a programmable logic unit, a microprocessor, and an application-specific integrated circuit (ASIC); however, example embodiments are not limited thereto. The memory controller 1601 may operate in response to a request from a host (not illustrated) and may be configured to convert the memory controller 1601 into a special-purpose controller by accessing the memory apparatus 1602 and controlling the control operations (e.g., write/read operations) described above. The memory controller 1601 may generate an address ADD and a command CMD for performing a program/read/erase operation on the memory cell array 1610. Also, in response to the command from the memory controller 1601, the voltage generator 1620 (e.g., a power circuit) may generate a voltage control signal for controlling the voltage level of a word line for programming/reading data into/from the memory cell array 1610.

In some cases, the memory controller 1601 may perform a determination operation on the data read from the memory apparatus 1602. For example, the number of on-cells and/or the number of off-cells may be determined from the data read from the memory cells. The memory apparatus 1602 may provide a pass/fail signal P/F to the memory controller 1601 according to the read result on the read data. The memory controller 1601 may control the write and read operations of the memory cell array 1610 with reference to the pass/fail signal P/F.

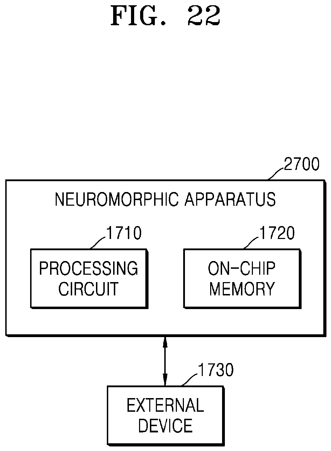

FIG. 22 is a block diagram illustrating a neuromorphic apparatus 2700 according to some example embodiments and an external device connected thereto.

Referring to FIG. 22, the neuromorphic apparatus 2700 may include a processing circuit 1710 and/or an on-chip memory 1720. The neuromorphic apparatus 2700 may include the memory devices 100, 200, 300, and 400 according to the embodiments described above.

In some example embodiments, the processing circuit 1710 may be configured to control a function for driving the neuromorphic apparatus 1700. For example, the processing circuit 1710 may be configured to control the neuromorphic apparatus 2700 by executing a program stored in the on-chip memory 1720. In some embodiments, the processing circuit 1710 may include hardware such as a logic circuit, a hardware/software combination such as a processor executing software, or a combination thereof. For example, the processor may include a CPU, a graphic processing unit (GPU), an application processor (AP) included in the neuromorphic apparatus 1700, an ALU, a digital signal processor, a microcomputer, an FPGA, an SoC, a programmable logic unit, a microprocessor, and an ASIC; however, example embodiments are not limited thereto. In some embodiments, the processing circuit 1710 may be configured to read/write various data with respect to an external device 1730 and/or execute the neuromorphic apparatus 2700 by using the read/written data. In some embodiments, the external device 1730 may include an external memory and/or a sensor array including an image sensor (e.g., a CMOS image sensor circuit).

In some example embodiments, the neuromorphic apparatus 2700 of FIG. 22 may be applied to a machine learning system. The machine learning system may use various artificial neural network structures and processing models, such as one or more of a convolutional neural network (CNN), a deconvolutional neural network, a recurrent neural network (RNN) selectively including a long short-term memory (LSTM) unit and/or a gated recurrent unit (GRU), a stacked neural network (SNN), a state-space dynamic neural network (SSDNN), a deep belief network (DBN), a generative adversarial network (GAN), and/or a restricted Boltzmann machine (RBM).

Alternatively or additionally, the machine learning system may include other types of machine learning models, for example, linear and/or logistic regression, statistical clustering, Bayesian classification, decision trees, dimensionality reduction such as principal component analysis, expert systems, and/or a combination thereof including ensembles such as random forests. The machine learning models may be used to provide various services and/or applications, and for example, image classification services, user authentication services based on biometric information or biometric data, advanced driver assistance system (ADAS) services, voice assistant services, and automatic speech recognition (ASR) services may be executed by the electronic apparatus.

Although the memory devices 100, 200, 300, and 400 have been described above with reference to various example embodiments illustrated in the drawings, this is merely an example and those of ordinary skill in the art will understand that various modifications and other equivalent embodiments may be derived therefrom. For example, example embodiments are not necessarily mutually exclusive with one another.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

It should be understood that various embodiments described herein should be considered in a descriptive sense only and not for purposes of limitation. Descriptions of features or aspects within each example embodiment should typically be considered as available for other similar features or aspects in other example embodiments. While one or more embodiments have been described with reference to the figures, it will be understood by those of ordinary skill in the art that various changes in form and details may be made therein without departing from the scope as defined by the following claims.

## Claims

1. A memory cell comprising:
first and second electrodes apart from each other;
a self-selecting memory layer between the first and second electrodes, having an ovonic threshold switching characteristic, comprising a chalcogenide-based material, and configured to have a threshold voltage varying depending on a polarity of and strength of a voltage applied thereto; and
a resistive memory layer between the second electrode and the self-selecting memory layer and having a resistance characteristic varying depending on a voltage applied thereto,
wherein the memory device is configured to implement multi-level resistance states by changing at least one of a pulse polarity, a number of pulses, a pulse height, and a pulse width of a voltage applied between the first and second electrodes.

2. The memory cell of claim 1, wherein the self-selecting memory layer and the resistive memory layer are electrically connected to each other in series.

3. The memory cell of claim 1 or 2, wherein the self-selecting memory layer comprises a chalcogen element including at least one of Se, Te, and S, and at least one of Ge, As, and Sb.

4. The memory cell of claim 3, wherein the self-selecting memory layer further comprises at least one of In, Al, C, B, Sr, Ga, O, N, Si, Ca, and P.

5. The memory cell of any preceding claim, wherein the resistive memory layer comprises at least one of Al₂O₃, In₂O₃, MgO, MoO₃, Ta₂O₅, TiO₂, HfO₂, PrCaMnO₃, V₂O₅, or ZnO.

6. The memory cell of any preceding claim, wherein the memory device is configured to have a pulse voltage of certain polarity applied between the first and second electrodes, and to have multi-level resistance states implemented by adjusting at least one of a number of pulses, a pulse height, and a pulse width of the pulse voltage, and optionally wherein the memory device is configured to have each of the multi-level resistance states determined by a sum of a first resistance of the self-selecting memory layer and a second resistance of the resistive memory layer.

7. The memory cell of any preceding claim, further comprising:
a third electrode between the self-selecting memory layer and the resistive memory layer.

8. The memory cell of any preceding claim, further comprising:
an insert layer in at least one of between the first electrode and the self-selecting memory layer, and between the second electrode and the resistive memory layer.

9. A memory device comprising:
a plurality of bit lines;
a plurality of word lines intersecting the plurality of bit lines; and
a plurality of memory cells according to any preceding claim where the plurality of bit lines and the plurality of word lines intersect each other.

10. A method of implementing a multi-level memory by using a memory device, the memory device comprising:
first and second electrodes apart from each other;
a self-selecting memory layer between the first and second electrodes, having an ovonic threshold switching characteristic, comprising a chalcogenide-based material, and configured to have a threshold voltage varying depending on a polarity of and a strength of a voltage applied thereto; and
a resistive memory layer between the second electrode and the self-selecting memory layer and having a resistance characteristic varying depending on a voltage applied thereto,
wherein the method comprises:
implementing multi-level resistance states by changing at least one of a pulse polarity, a number of pulses, a pulse height, and a pulse width of a voltage applied between the first and second electrodes.

11. The method of claim 10, wherein the self-selecting memory layer and the resistive memory layer are electrically connected to each other in series.

12. The method of claim 10 or 11, further comprising:
applying a pulse voltage of certain polarity between the first and second electrodes; and
implementing multi-level resistance states by adjusting at least one of a number of pulses, a pulse height, and a pulse width of the pulse voltage, and optionally further comprising:
determining each of the multi-level resistance states by summing a first resistance of the self-selecting memory layer and a second resistance of the resistive memory layer.

13. The method of claim 12, wherein, as the pulse height increases, the first resistance and the second resistance change.

14. The method of claim 12, wherein, as the number of pulses increases, the first resistance is constant and the second resistance changes.

15. The method of claim 12, wherein, as the pulse width increases, the first resistance is constant and the second resistance changes.
